# EUROPEAN PATENT APPLICATION

(11) **EP 0 646 800 A1**
(43) Date of publication of application: **05.04.1995**
(21) Application number: 94307096.1
(22) Date of filing: 28.09.1994
(51) Int. Cl.: G01R 1/073

(54) **Probe for testing semi-conductor chips**

(30) Priority: 30.09.1993 JP 244385/93
(71) Applicant: International Business Machines Corporation, Armonk, N.Y. 10504 (US)
(72) Inventor: Hirano, Toshiki, Tokyo-to (JP); Kimura, Atsuo, Ohtsu-shi, Shiga-ken (JP); Mori, Shinichiro, Kusatsu-shi, Shigak-ken (JP)
(74) Representative: Richards, John Peter

(57) **Abstract**

A probe for testing semi-conductor chips comprising a silicon substrate 120 with a plurality of recesses 140. A film 130 on the surface of the substrate extends over each recess. Contacts 101 are formed on the film 130 over the recesses 140, and conductive leads 110 are connected to the contacts. The film 130 permits a degree of resilient differential vertical movement of the contacts.

## Description

The invention relates to a probe for testing semiconductor chips.

In LSI manufacturing, after a plurality of chips are formed on a wafer it is necessary to test their electrical operation. This is performed typically as follows:
Chip manufacturing process => continuity test => dicing => packaging => acceleration test => shipping

Here, the test process consists of a continuity test and an acceleration test, and the dicing and packaging processes are placed between them. The continuity test determines whether or not the electrical operation of each individual chip is normal. The chips in which normal operation is confirmed will be cut chip by chip in the dicing process thereafter. This is called the die state. Next, these individual chips are packaged and an acceleration test (a test to simulate long-time operation by operating a circuit at a high temperature of about 150 ΦC) is carried out.

The acceleration test was performed in the past after completion of packaging. However, in the recent multi-chip module technology (MCM) the desirability of guaranteeing chips at a stage before being connected with external equipment has arisen. The chips in this stage are called bare chips. Moreover, if chips can be tested in batch at a stage before dicing, a cost advantage will accrue.

Thus it would be desirable to carry out an acceleration test at the wafer level as follows:
Chip manufacturing process => continuity test at wafer level => acceleration test at wafer level => dicing ...

However, it is difficult to electrically connect wafers to be tested with a probe card, which is a conventional connection tool, in cases where an acceleration test is carried out at the wafer level at high temperatures. Probe cards are not suitable for high density products or, due to differential expansion between the card and the wafer, use at high temperatures.

It is an object of this invention to provide an improved probe for testing semi-conductor chips.

The invention is defined in the attached claims.

Embodiments of the invention will now be described, by way of example, with reference to the accompanying drawings, in which:
Figure 1 is a top view of a microprobe according to a first embodiment of the invention;
Figure 2 is a sectional side view of the microprobe of Figure 1 in contact with an LSI chip to be tested;
Figures 3 to 8 illustrate steps in the manufacture of the microprobe of Figure 1;
Figure 9 is a sectional view of a second embodiment of a microprobe according to the invention;
Figures 10 to 14 illustrates steps in the manufacture of the microprobe of Figure 9;
Figure 15 is a sectional view of a third embodiment of a microprobe according to the invention; and
Figures 16 to 20 illustrates steps in the manufacture of the microprobe of Figure 15.

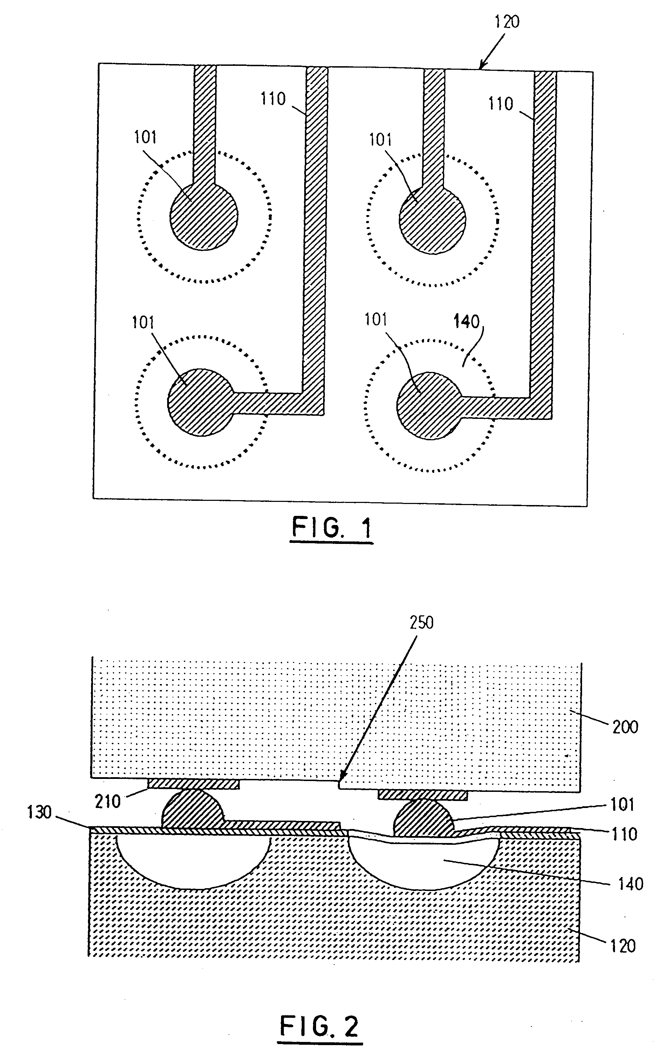

Referring to Figures 1 and 2, a probe for testing semi-conductor chips (hereinafter referred to as a microprobe) comprises a substrate 120 with a plurality of cavities or recesses 140 formed in its surface. A film 130 is provided on the surface of the substrate 120 overlying the recesses 140, and a plurality of conductive projections or contacts 101 are formed on and supported by the film over the recesses. Respective conductive leads 110 formed on the film 130 are connected to the contacts 101, and permit connection of the contacts to external test equipment.

The contacts 101 are formed on the film 130 in a pattern which matches the pattern of contact pads 210 on an LSI chip 200 to be tested, so that when the substrate is placed in face to face contact with the chip 200 the contacts 101 can contact the pads 210 in one-to-one correspondence. In this embodiment the recesses 140 are provided one under each contact 101 respectively, and hence they too match the pattern of the pads 210. However, if desired a single recess 140 can be provided under more than one contact 101 especially where the latter are very close together. Although only four contacts 101 are shown in Figure 1, in general there will of course be many more in practice.

The contacts 101 and leads 110 should be made of a material with a low electrical resistance, such as gold, copper or their alloys. The substrate 120 is preferably of the same semiconductor material as the wafer 200 to be tested, typically silicon. This is to avoid positional dislocation caused by differential thermal expansion when heating in the acceleration test.

The film 130 upon which the contacts 101 and leads 110 are formed is an organic film such as polyimide. In addition, although not illustrated in Figure 2, the film 130 may also include an oxide film, such as silicon oxide, between the organic film and the silicon substrate.

The reason why such a structure is employed is to permit a degree of resilient differential movement of the contacts 101 normal to the substrate 120 (i.e. normal to the plane of Figure 1). Thus the resilience of the film 130 should be sufficient to accommodate steps 250 in the surface of the chip 200, thereby allowing the contacts 101 to come into contact with the pads 210 at a more uniform contact pressure than if the contacts were rigidly secured to the surface of the substrate 120. In this way, the embodiment provides a probe having a large tolerance for differences in surface height of an LSI chip. In surface areas of the LSI chip where there is little difference in height, the structure can be designed such that one recess 140 is formed below a plurality of contacts 101.

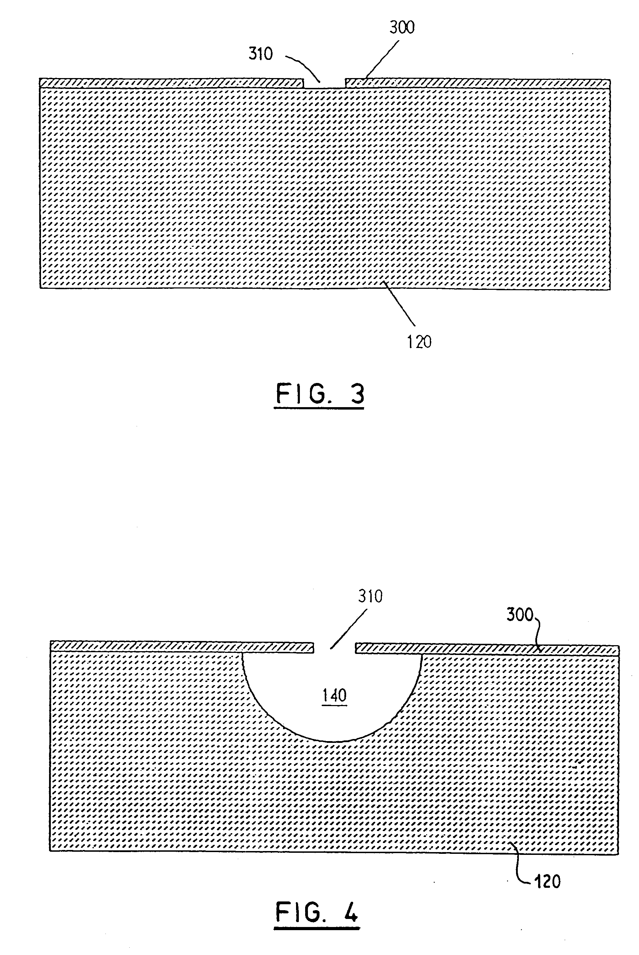

An example of how the above embodiment can be manufactured will now be described. First, a silicon oxide film 300 several thousands of Angstroms in thickness is formed on a silicon substrate as shown in Figure 3. Then small holes 310 (only one of which is shown) are made in the oxide film 300 by the known photolithography and etching techniques. As referred to above, in this embodiment the positions of these holes must match the positions of the contact pads 210 on the LSI to be tested.

The silicon substrate 120 is thereafter etched through the holes 310 by a plasma etching technique, Figure 4. As a result, the silicon substrate below each hole 310 is etched selectively and isotropically, and a recess 140 is formed whose diameter is greater than the diameter of the hole 310.

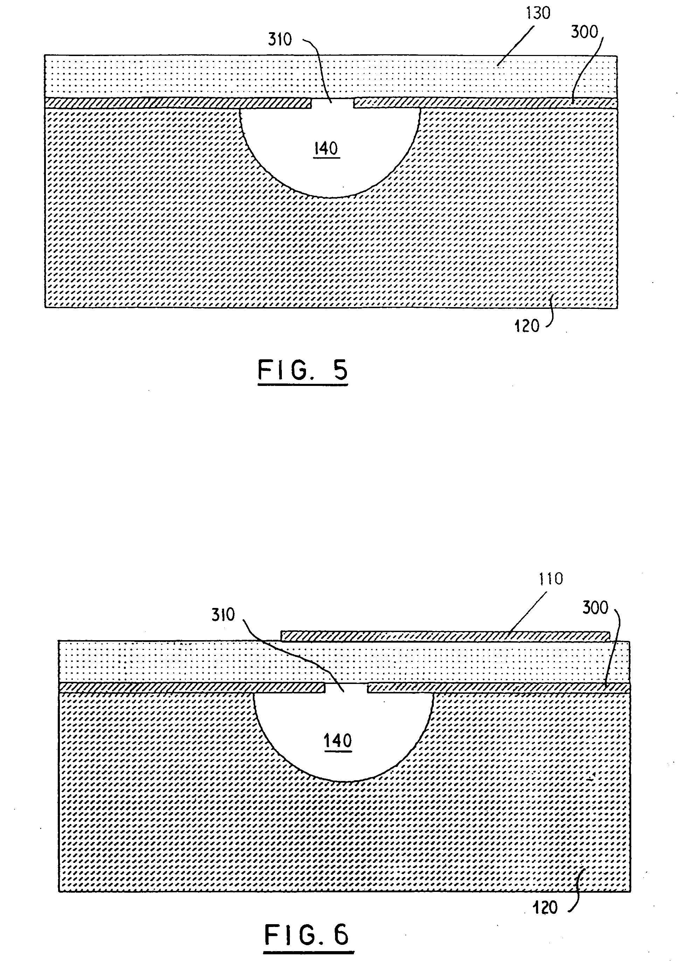

Next, a blanket organic film 130 several micrometers in thickness is deposited on the oxide film 300, Figure 5. This organic film 130 is applied by spin coating a polyimide or other suitable material in a liquid state; however, the viscosity of the liquid is sufficiently large to avoid the liquid entering the recess 140 through the hole 310. A metal lead 110 is then formed, as shown in Figure 6.

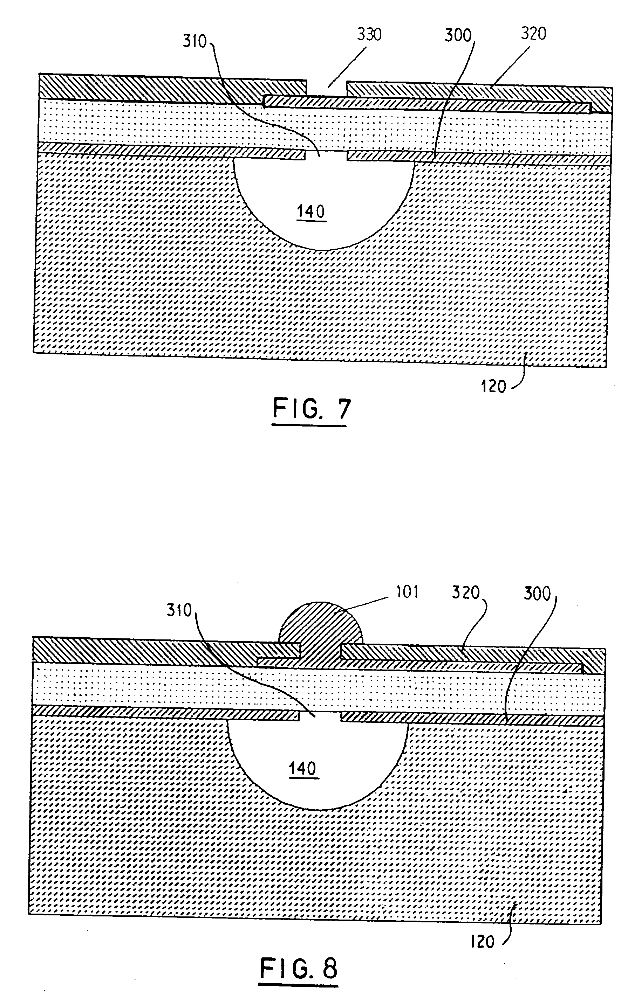

Then, as shown in Figure 7, a photoresist layer 320 is applied and patterned to form apertures 330 at those places where the contacts 101 are to be formed.

Finally, as shown in Figure 8, metal contacts 101 are formed by electroplating the portions of the leads 110 exposed by the photoresist layer 320, and the photoresist layer is then removed.

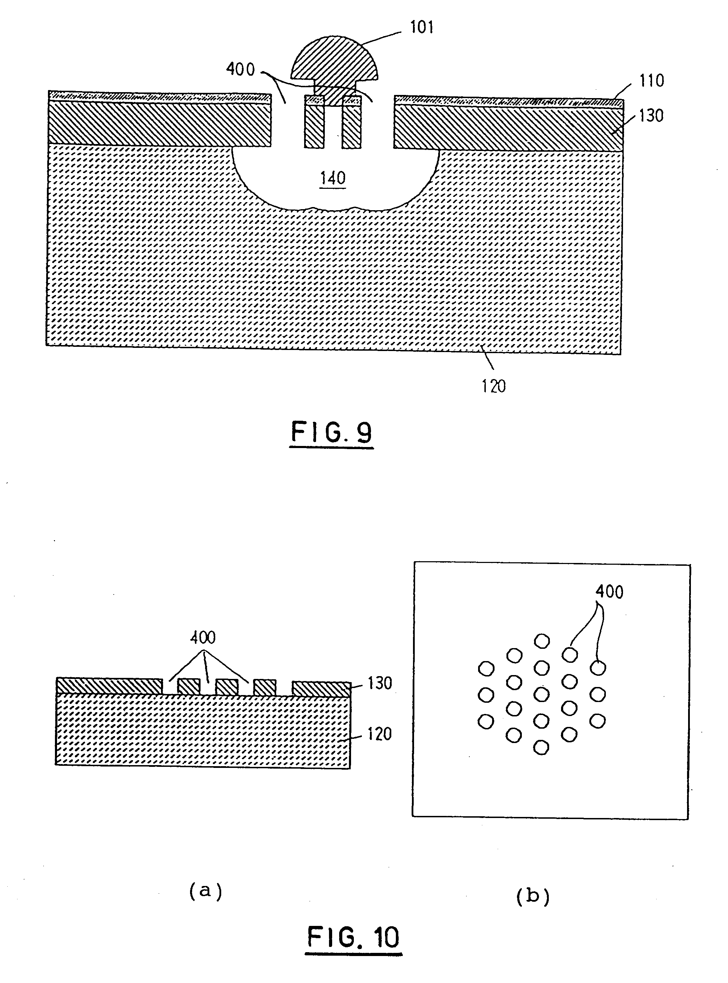

Figure 9 shows a second embodiment of the invention. Those elements which are the same or equivalent to elements of the first embodiment are given the same reference numbers. In this case a plurality of holes are formed in the film 130.

Figures 10 to 14 show a manufacturing process for the second embodiment 2. In each figure, view (a) is a sectional view and view (b) is a top view. While only one contact is shown being made, there will of course be many being manufactured simultaneously on the same substrate.

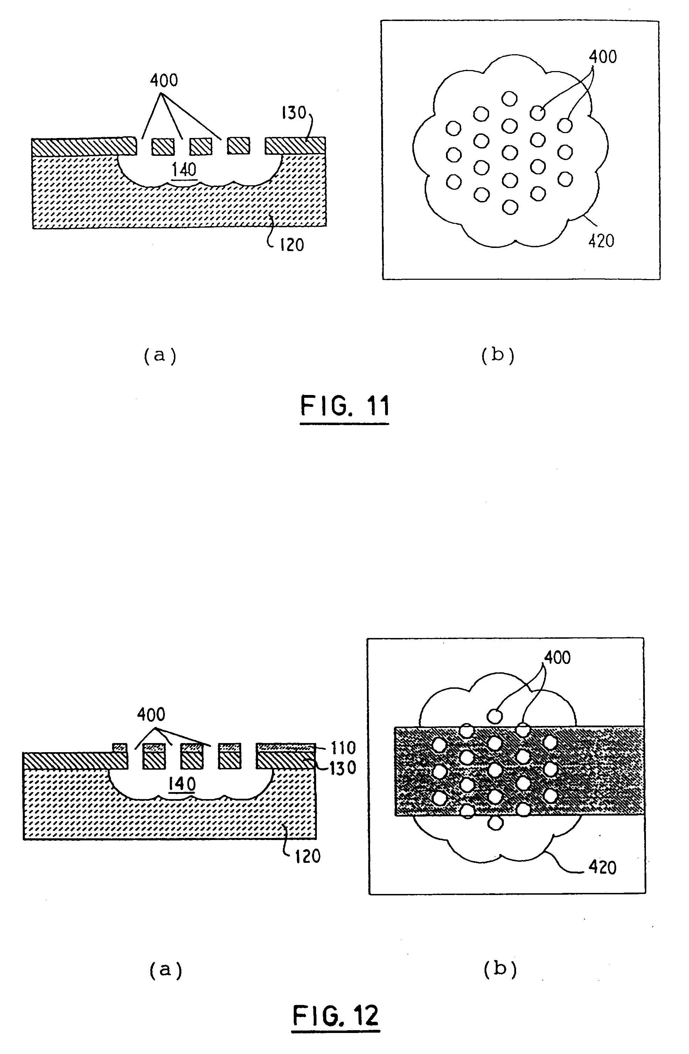

First, Figure 10, an organic film 130 is uniformly applied on the silicon substrate 120, hardened by baking, and then a plurality of small holes 400 about 5 um in diameter are formed in the area 420 (Figure 11(b)) where the recess 140 is to be formed. Next, Figure 11, the silicon substrate 120 is etched isotropically by plasma etching. As a result, a recess 140 is formed below the holes.

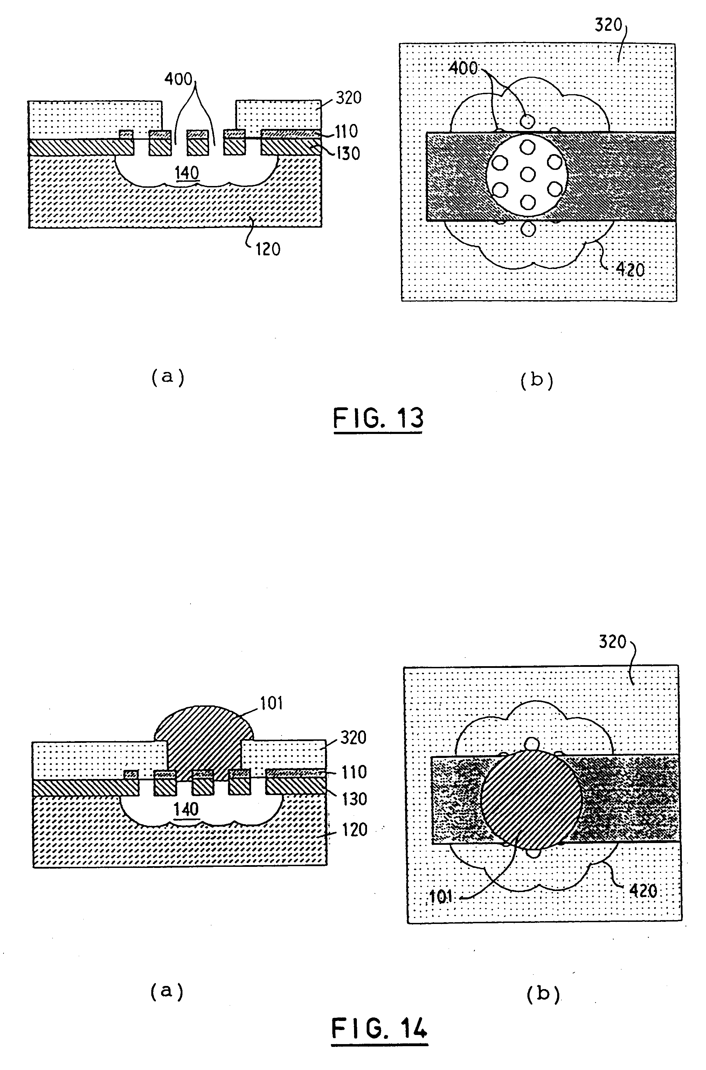

Next, Figure 12, the metal lead 110 is formed on the organic film 130. Then, Figure 13, a photoresist 320 is applied and the region of the lead 110 above the recess 140 is exposed. Finally, Figure 14, a contact 101 is formed by electroplating after which the photoresist layer is removed.

By employing such a method, since holes are formed on an organic film which is applied in advance instead of applying an organic film on holes, as in the first embodiment, much higher yields can be expected.

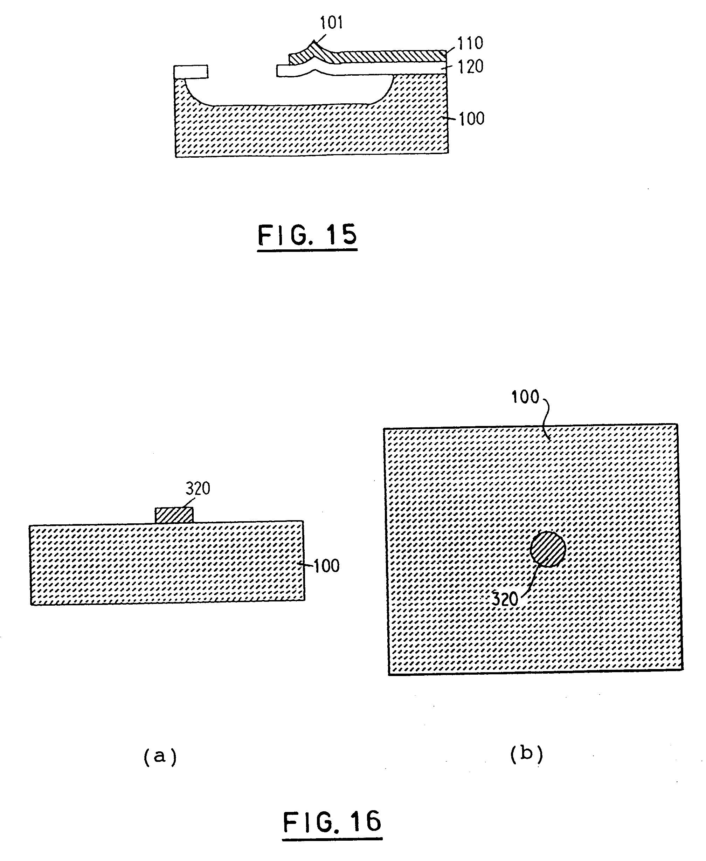

Figure 15 shows another embodiment of the invention. Again only a single contact 101 is shown, although there will be many in practice. This structure is designed such that the contact is of a resilient cantilever structure and employs a needle-like contact section 101 instead of the spherical contact section which is seen in embodiments 1 and 2. In addition, the structure does not use an organic film, but only a silicon oxide film 120. The manufacturing process is shown in Figures 16 to 20. As before, both top and side views are shown.

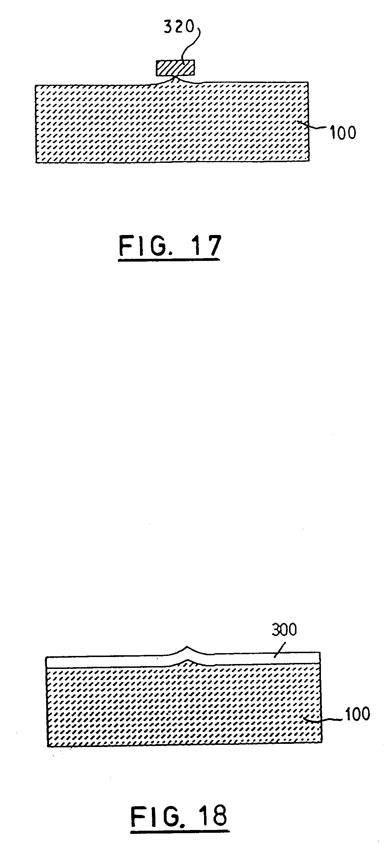

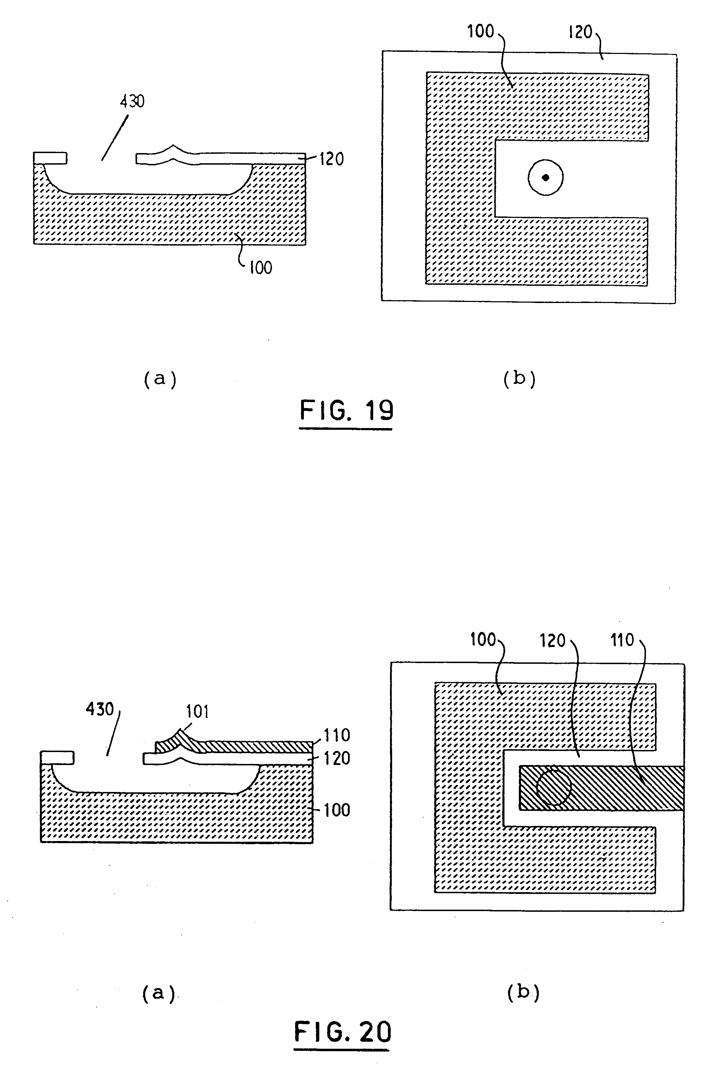

As shown in Figure 16, a circular portion of photoresist 320 is left at a predetermined position on the silicon substrate 100. Next, the whole is etched isotropically as shown in Figure 17 to leave an upstanding point under the photoresist. The substrate surface is oxidized by heat thereafter to form an oxide film 300 as shown in Figure 18. Now, by etching or other suitable method, a small hole is made at a part of oxide film adjacent the point, as shown in Figure 19. Then, a cantilever structure, such as shown in Figure 15, can be obtained by forming a metal lead 110 and etching the silicon layer isotropically as shown in Figure 20. This structure implements stable electrical contact because the contact section is formed in needle form.

The advantage of the embodiments is that the probe structure is created in a batch system using semi-conductors. Therefore, a very small structure can be manufactured by a comparatively simple process. Moreover, since silicon, which is identical to the substrate of chip to be tested, is used as the substrate material, positional dislocation due to differential thermal expansion in acceleration testing will not occur. In addition, it is possible to create a probe having a large area.

## Claims

1. A probe for testing semi-conductor chips, comprising a substrate, a plurality of recesses formed in the surface of the substrate, a film on the surface of the substrate and extending at least partially over each recess, a plurality of contacts formed on the film over the recesses, and conductive leads connected to the contacts, the film permitting a degree of resilient differential movement of the contacts normal to the substrate.

2. A probe as claimed in claim 1, wherein the film has at least one hole over each recess.

3. A probe as claimed in claim 1 or 2, wherein the film comprises an oxide film.

4. A probe as claimed in claim 1, 2 or 3, wherein the film comprises an organic film.

5. A probe as claimed in claim 1, 2 or 3, wherein the film extends as a cantilever over the recess.

6. A probe structure as claimed in any preceding claim, wherein the substrate is made of semiconductor material.
